Europäisches Patentamt

European Patent Office

Office européen des brevets

(19)

(11) Veröffentlichungsnummer: **0 510 704 A1**

## (12) EUROPÄISCHE PATENTANMELDUNG

(21) Anmeldenummer: **92107119.7**

(22) Anmeldetag: **25.04.92**

(51) Int. Cl.5: **H03G 1/00**, H03G 7/06

(30) Priorität: **25.04.91 DE 4113498**

(43) Veröffentlichungstag der Anmeldung:
**28.10.92 Patentblatt 92/44**

(84) Benannte Vertragsstaaten:
**PT**

(71) Anmelder: **DEUTSCHE THOMSON-BRANDT GMBH**

**W-7730 Villingen-Schwenningen(DE)**

(72) Erfinder: **Itri, Sossio**
**Bromer Strasse 11**
**W-3180 Wolfsburg 11(DE)**
Erfinder: **Rieger, Martin**
**Zepfenhaner Strasse 15**
**W-7210 Rottweil-Neukirch(DE)**

(54) **Schaltung für einen regelbaren Verstärker.**

(57) Es sind regelbare Verstärker bekannt, die z.B. zur Amplitudenregelung von ZF-Signalen verwendet werden. Ein solcher Verstärker ist beispielsweise in dem integrierten Schaltkreis vom Typ TDA 4443 enthalten. Diese bekannten Verstärker sind aber nicht rauscharm oder haben eine eingeschränkte Linearität oder die Regelcharakteristik ist nicht dB-linear. Um eine verbesserte Regelungscharakteristik zu erhalten, wird in einem Differenzverstärker (Q21,Q22) das Gegenkopplungs-Netzwerk aufgeteilt in einzelne Netzwerke, die jeweils mit einem eigenen Steuerstrom ($I_1...I_3$) versorgt werden. Um Verzerrungen durch in den Netzwerken enthaltene nichtlineare Strecken gering zu halten bzw. die Intermodulationsfestigkeit zu erhöhen, werden die einzelnen Steuerströme ($I_1...I_3$) mit ansteigender Eingangsspannung verringert. Zur Realisierung einer dB-linearen Regelcharakteristik können die Steuerströme z.B. tanh-förmige (tangens hyperbolicus) Kennlinien erhalten. Außerdem ist ein solcher Verstärker relativ rauscharm.

FIG.2

EP 0 510 704 A1

Die Erfindung betrifft eine Schaltung für einen regelbaren Verstärker.

## Stand der Technik

Es sind regelbare Verstärker bekannt, die z.B. zur Amplitudenregelung von ZF-Signalen verwendet werden. Ein solcher Verstärker ist beispielsweise in dem integrierten Schaltkreis vom Typ TDA 4443 enthalten. Diese bekannten Verstärker sind aber nicht rauscharm oder haben eine eingeschränkte Linearität oder die Regelcharakteristik ist nicht dB-linear.

## Erfindung

Der Erfindung liegt die Aufgabe zugrunde, eine Schaltung für einen regelbaren Verstärker mit erhöhter Linearität und verbessertem Rauschverhalten anzugeben. Diese Aufgabe wird durch die in Anspruch 1 angegebene erfindungsgemäße Schaltung gelöst.

Im Prinzip ist die erfindungsgemäße Schaltung versehen mit einem Differenzverstärker für eine Eingangsspannung, der einen ersten Transistor und einen zweiten Transistor enthält, die durch eine Serienschaltung von mindestens drei Widerständen verbunden sind, wobei zwischen diesen Widerständen jeweils mindestens ein Bauelement abzweigt, welches jeweils mit mindestens einer Stromquelle verbunden ist und wobei der Strom dieser Stromquellen in Abhängigkeit von der Eingangsspannung veränderbar ist.

Vorteilhaft ist dabei insbesondere bei einer dB-linearen Regelung der Strom der Stromquellen zusätzlich von einer Referenzspannung abhängig, wobei die jeweilige Referenzspannung für die in der Mitte der Serienschaltung liegenden Bauelemente am niedrigsten und für die am nächsten zu den Enden der Serienschaltung liegenden Bauelemente am höchsten ist. Vorteilhaft bei einer linearen Regelung ist, daß die Ströme der Stromquellen proportional zueinander sind und von der Mitte zu den Enden der Serienschaltung hin kleiner werden.

Vorteilhafte Weiterbildungen der erfindungsgemäßen Schaltung ergeben sich aus den entsprechenden Unteransprüchen.

In einem Differenzverstärker wird das Gesamt-Gegenkopplungs-Netzwerk aufgeteilt in einzelne Netzwerke, die jeweils mit mindestens einem eigenen Steuerstrom versorgt werden. Um Verzerrungen durch in den Netzwerken enthaltene nichtlineare Bauelemente, z.B. Diodenstrecken, gering zu halten bzw. die Intermodulationsfestigkeit zu erhöhen, werden die einzelnen Steuerströme mit ansteigender Eingangsspannung kleiner. Zur Realisierung einer dB-linearen Regelcharakteristik können die Steuerströme z.B. tanh-förmige (tangens hyperbolicus) oder ähnliche Kennlinien erhalten. Außerdem ist ein solcher Verstärker aufgrund seiner Struktur und seines Funktionsprinzips relativ rauscharm.

## Zeichnungen

Anhand der Zeichnungen werden Ausführungsbeispiele der Erfindung beschrieben. Die Zeichnungen zeigen in:

Fig. 1    bekannte Schaltung für einen regelbaren Verstärker;

Fig. 2    erfindungsgemäße Schaltung für einen regelbaren Verstärker;

Fig. 3    Steuerstrom-Kennlinien für den Verstärker nach Fig. 2;

Fig. 4    Steuerstrom-Kennlinien für eine dB-lineare Regelcharakteristik;

Fig. 5    Schaltung zur Erzeugung von Kennlinien nach Fig. 4;

Fig. 6    Verstärker-Block aus mehreren Einzelverstärkern;

Fig. 7    Steuerstrom-Kennlinien für eine lineare Regelcharakteristik;

Fig. 8    eine weitere erfindungsgemäße Schaltung für ei nen regelbaren Verstärker.

## Ausführungsbeispiele

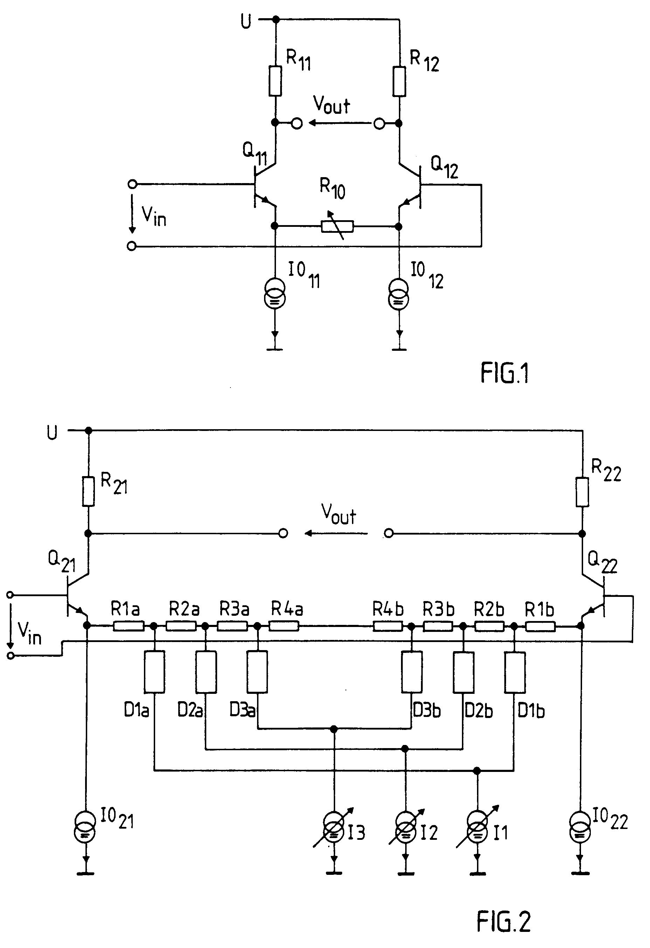

Fig. 1 enthält einen ersten Transistor $Q_{11}$ und einen zweiten Transistor $Q_{12}$, die als Differenzverstärker geschaltet sind. Die Kollektoren dieser Transistoren sind über einen ersten Widerstand $R_{11}$ bzw. zweiten Widerstand $R_{12}$ an die Versorgungsspannung U angeschlossen. Die Emitter dieser Transistoren sind über eine erste Stromquelle $IO_{11}$ bzw. zweite Stromquelle $IO_{12}$ an Masse angeschlossen. Den Basen der beiden Transistoren wird die Eingangsspannung $V_{in}$ zugeführt. Zwischen den Kollektoren der beiden Transistoren ist die Ausgangsspannung $V_{out}$ abgreifbar. Zwischen den Emittern der beiden Transistoren ist ein regelbarer Widerstand $R_{10}$ angeschlossen, mit dem die Verstärkung der Schaltung eingestellt werden kann. Für $R_{11} = R_{12} = R$ und $IO_{11} = IO_{12} = IO$ gilt:

$$V_{out} = V_{in}*R/R_{10}$$

Fig. 2 enthält ein Netzwerk aus acht in Reihe geschalteten Widerständen R1a-R4a und R1b-R4b, aus sechs jeweils zwischen diesen Widerständen abgehenden Bauelementen D1a-D3a und D1b-D3b und aus drei einseitig an Masse liegenden und an diese Bauelemente angeschlossenen Stromquellen I1-I3, das den regelbaren Widerstand $R_{10}$ aus Fig. 1 ersetzt.

Im Fall einer Bipolar-Schaltung können die sechs Bauelemente Dioden sein, deren Durchlaßrichtung zu den Stromquellen I1-I3 zeigt. Der Wechselstromwiderstand dieser Dioden ist dabei gleich $V_T/I$, wobei $V_T$ die Temperaturspannung und I der durch die Diode fließende Strom ist.

Im Fall einer MOS-Schaltung können die sechs Bauelemente als einstellbare Widerstände ausgebildete FET-Transistoren sein. Besonders lineare Widerstände dieser Art lassen sich durch die Kombination von N-MOS- und P-MOS-Transistoren erreichen.

Die Schaltungsteile $Q_{21}$, $Q_{22}$, $R_{21}$, $R_{22}$, $IO_{21}$ und $IO_{22}$ entsprechen den Schaltungsteilen $Q_{11}$, $Q_{12}$, $R_{11}$, $R_{12}$, $IO_{11}$ und $IO_{12}$ aus Fig. 1. Die Anzahl der den Widerstand $R_{10}$ ersetzenden Schaltungsteile bzw. die Anzahl der hintereinandergeschalteten Teilerstufen kann entsprechend den Erfordernissen für den Regelumfang unter Berücksichtigung der zur Verfügung stehenden Betriebsspannungshöhe variiert werden.

Wenn beginnend bei einem kleinen Pegel die Eingangsspannung $V_{in}$ ansteigt, wird zunächst der Strom in der Stromquelle I1 zurückgenommen. Dadurch wird das Bauelement (die Diode) D1a bzw. D1b hochohmig, der Einfluß eventueller, durch große Pegel an D1a bzw. D1b bedingter Verzerrungen auf die Gesamtverzerrungen des Verstärkers wird vernachlässigbar und die Verstärkung wird entsprechend verringert. Die Bauelemente R1a und R2a bzw. R1b und R2b wirken nun für das Bauelement D2a bzw. D2b wie ein Spannungsteiler mit vergrößertem Teilerverhältnis, sodaß für die Eingangsspannung $V_{in}$ in Bezug auf D2a bzw. D2b größere Pegel zulässig sind. Dieser Vorgang setzt sich für weiter ansteigende Eingangsspannungen für die entsprechenden folgenden Bauelemente fort.

Es kann beispielsweise folgende Dimensionierung vorgenommen werden:

$R_{21}$ = $R_{22}$ = 3.9 kΩ
R1a = R1b = 100 Ω
R2a = R2b = 1.38kΩ
R3a = R3b = 1.26kΩ
R4a = R4b = 1.26kΩ

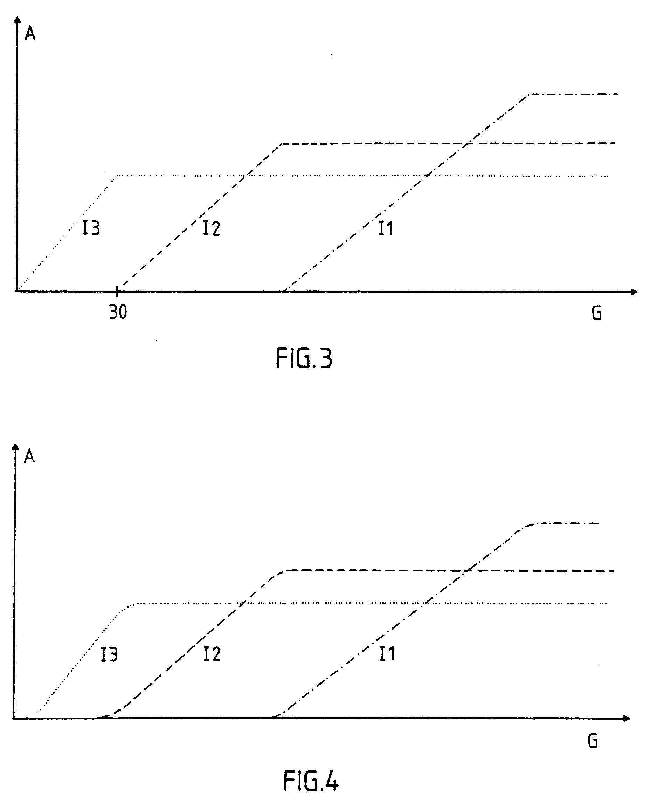

In Fig. 3 ist der Amplitudenverlauf A der Steuerströme der Stromquellen I1, I2 und I3 über der Verstärkung G aufgetragen. Bei großer Verstärkung (d.h. kleiner Eingangsspannung $V_{in}$) haben alle Steuerströme ihren Maximalwert. Bei steigender Eingangsspannung (d.h. sinkender Verstärkung) wird zunächst Steuerstrom der Stromquelle 11 zurückgenommen. Spätestens wenn dieser Steuerstrom zu Null geworden ist, fällt der Steuerstrom der Stromquelle I2. Spätestens wenn dieser Steuerstrom zu Null geworden ist, fällt der Steuerstrom der Stromquelle I3. Wenn dieser Steuerstrom zu Null geworden ist, liegt die Minimal-Verstärkung vor. Entsprechendes gilt für eventuelle weitere Steuerströme.

Auf diese Weise kann die Ausgangsspannung $V_{out}$ innerhalb des Verstärker-Regelbereichs unabhängig vom Pegel der Eingangsspannung $V_{in}$ konstant gehalten werden, wobei die Linearität innerhalb dieses Regelbereichs gegenüber dem bekannten Regelverstärker deutlich erhöht ist.

Durch den Verlauf der Steuerströme der Stromquellen I1-I3 kann die Regelcharakteristik des Verstärkers in Fig. 2 entsprechend beeinflußt werden. Durch einen höheren Steuerstrom kann auch eine höhere Maximalverstärkung erreicht werden. Die Anzahl der Steuerströme kann den jeweiligen Erfordernissen an den Gesamt-Regelbereich und an die Linearität angepaßt werden, jedoch ist bei steigender Anzahl von Steuerströmen oder bei steigendem Betrag der Steuerströme auch eine entsprechend erhöhte Betriebsspannung U erforderlich. Der Verstärkungs-Faktor 30 an der Stelle, wo der Steuerstrom der Stromquelle I2 zu Null geworden ist und der Steuerstrom der Stromquelle I3 gerade mit der Absenkung beginnt sowie die entsprechenden Verstärkungfaktoren für die anderen Steuerströme, lassen sich durch Referenzspannungen festlegen, die der jeweiligen Stromquelle I1, I2 und I3 zugeführt werden.

Ein ZF-Verstärker hat z.B. einen Regelumfang von 60dB. Wenn mit einer Kontrollspannung $V_{AGC}$ beispielsweise eine Verstärkung von 6dB eingestellt werden soll, ergibt sich bei einer linearen Regelungscharakteristik diese Kontrollspannung zu nur

$V_{AGC6dB}$ = (2/1000)*$V_{AGCmax}$      (6dB = Faktor 2, 60dB = Faktor 1000).

Bei einer dB-linearen Regelungscharakteristik ergäbe sich dagegen eine Kontrollspannung von

$V_{AGC6dB}$ = (6/60)*$V_{AGCmax}$.

Darum hat eine dB-lineare Regelungscharakteristik Vorteile bezüglich der Einfachheit der Regelung, der Regelgeschwindigkeit und der Regelstabilität (Regelsprünge).

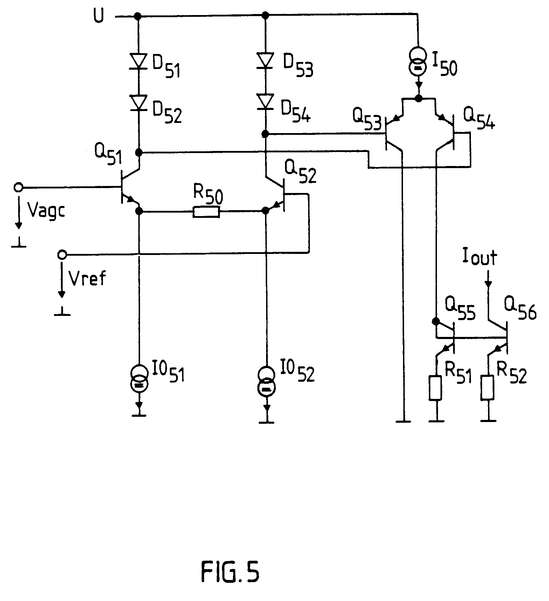

Mit der erfindungsgemäßen Schaltung läßt sich vorteilhaft leicht eine solche dB-lineare Regelungscharakteristik erreichen. In Fig. 4 ist ein entsprechend verbesserter Amplitudenverlauf A der Steuerströme der Stromquellen I1, I2 und I3 über der Verstärkung G aufgetragen. Die einzelnen Kennlinien haben einen tanh-ähnlichen Verlauf. Die Aussagen zu Fig. 3 gelten hier entsprechend.

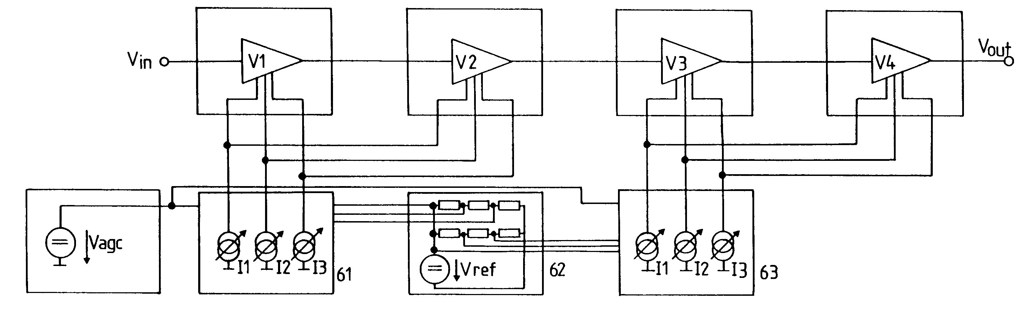

Mit einer Stromquellen-Schaltung nach Fig. 5 läßt sich eine Stromquelle I1, I2, oder I3 realisieren, die eine der Fig. 4 entsprechende Kennlinie hat. Den drei Stromquellen-Schaltungen wird die gemeinsame Kontrollspannung $V_{AGC}$ und jeweils eine individuelle Referenzspannung $V_{ref}$ zugeführt. Die Kontrollspannung $V_{AGC}$ und die Referenzspannung $V_{ref}$ gelangen zu zwei Differenzverstärker-Transistoren $Q_{51}$ bzw. $Q_{52}$, deren Emitter mit einem Widerstand $R_{50}$ untereinander und jeweils über eine Stromquelle $IO_{51}$ bzw. $IO_{52}$ mit Masse verbunden

sind. Der Kollektor von $Q_{51}$ ist über zwei Dioden $D_{51}$ und $D_{52}$ und der Kollektor von $Q_{52}$ ist über zwei Dioden $D_{53}$ und $D_{54}$ mit der Betriebsspannung U verbunden. Die Spannungsdifferenz zwischen den beiden Kollektoren wird auf die Basisanschlüsse eines weiteren Differenzverstärker-Transistorenpaars $Q_{53}$ und $Q_{54}$ gegeben und somit in Abhängigkeit vom Differenzverstärker mit den Transistoren $Q_{51}$ und $Q_{52}$ gesteuert. Die Emitter von $Q_{53}$ und $Q_{54}$ sind über eine dritte Stromquelle $I_{50}$ mit der Betriebsspannung verbunden. Der Kollektor von $Q_{53}$ liegt an Masse. Der Kollektor von $Q_{54}$ ist mit Basis und Kollektor eines fünften Transistors $Q_{55}$ verbunden, dessen Emitter über einen zweiten Widerstand $R_{51}$ an Masse liegt und dessen Basis an die Basis eines sechsten Transistors $Q_{56}$ angeschlossen ist. Der Emitter des sechsten Transistors liegt über einen dritten Widerstand $R_{52}$ an Masse. Am Kollektor ist der jeweilige Steuerstrom der Stromquelle I1, I2 oder I3 abgreifbar.

Es sei $v = (V_{AGC}-V_{ref})$, $I_0$ der von den Stromquellen $IO_{51}$ und $IO_{52}$ und $IO_{52}$ der von der Stromquelle $I_{50}$ eingeprägte Strom. Dann ergibt sich der jeweilige Ausgangsstrom $I_{out}$ zu

$$I_n = C*IO_{50}*[1/(1 + ((IO + v/R_{50})/(IO-v/R_{50}))^k)],$$

wobei n der Index der jeweiligen Kennlinie (n = 1,2,3), k die Anzahl der hintereinandergeschalteten Dioden und C eine Konstante ist, z.B. C = 3. In der Stromquellen-Schaltung nach Fig. 5 ist daher k = 2. Die jeweilige Steilheit der Steuerstrom-Kennlinien ist durch $R_{50}$ und das Verhältnis $IO_{50}/I_0$ und der jeweilige Maximalwert des Steuerstroms durch $IO_{50}$ gegeben.

Es kann beispielsweise für den in Fig. 6 beschriebenen ersten Stromquellenblock 61 folgende Dimensionierung vorgenommen werden:

U = 7.7V
Stromquelle I1:
$R_{50}$ = 8.0kΩ
$R_{51}$ = $R_{52}$ = 2.7kΩ
$I_0$ = 167µA
Strom von $I_{50}$ = 103µA
$V_{ref}$ = 3.624V
Stromquelle I2:
$R_{50}$ = 10.0kΩ
$R_{51}$ = $R_{52}$ = 2.25kΩ
$I_0$ = 50.6µA
Strom von $I_{50}$ = 103µA
$V_{ref}$ = 2.676V
Stromquelle 13:
$R_{50}$ = 4.0kΩ
$R_{51}$ = $R_{52}$ = 1.5kΩ
$I_0$ = 50.5µA
Strom von $I_{50}$ = 103µA
$V_{ref}$ = 2.179V
Für den in Fig. 6 beschriebenen zweiten Stromquellenblock 63 ergibt sich folgende abweichende Dimensionierung:
Stromquelle I1:
$I_0$ = 169µA
$V_{ref}$ = 5.67V
Stromquelle I2:
$I_0$ = 51.4µA
$V_{ref}$ = 4.766V
Stromquelle I3:
$I_0$ = 51.3µA
$V_{ref}$ = 4.326V
Der ZF-Verstärker-Block in Fig. 6 enthält vier Einzelverstärker V1-V4, die jeweils einem regelbaren Verstärker nach Fig. 2 entsprechen. Die von diesen Regelverstärkern benötigten Steuerströme liefern sechs Stromquellen-Schaltungen gemäß Fig. 5, von denen die ersten drei zu einem ersten Stromquellen-Block 61 und die anderen drei zu einem zweiten Stromquellen-Block 62 zusammengefaßt sind. Der erste Stromquellen-Block 61 steuert den ersten V1 und zweiten V2 Einzelverstärker und der zweite Stromquellen-Block 63 den dritten V3 und vierten V4 Einzelverstärker. Die Anzahl der Stromquellen-Blöcke kann je nach verlangter Regelqualität zwischen eins und vier liegen.

Ein Stromquellen-Block entspricht jeweils drei Stromquellen-Schaltungen nach Fig. 5. Die Stromquellen-Blöcke erhalten die gemeinsame Kontrollspannung $V_{AGC}$, aber individuelle Referenzspannungen aus dem Referenzspannungsblock 62.

Vorteilhaft können die hintereinandergeschalteten Regelverstärker den wesentlichen Anteil eines integrierten ZF-Verstärker-Schaltkreises bilden.

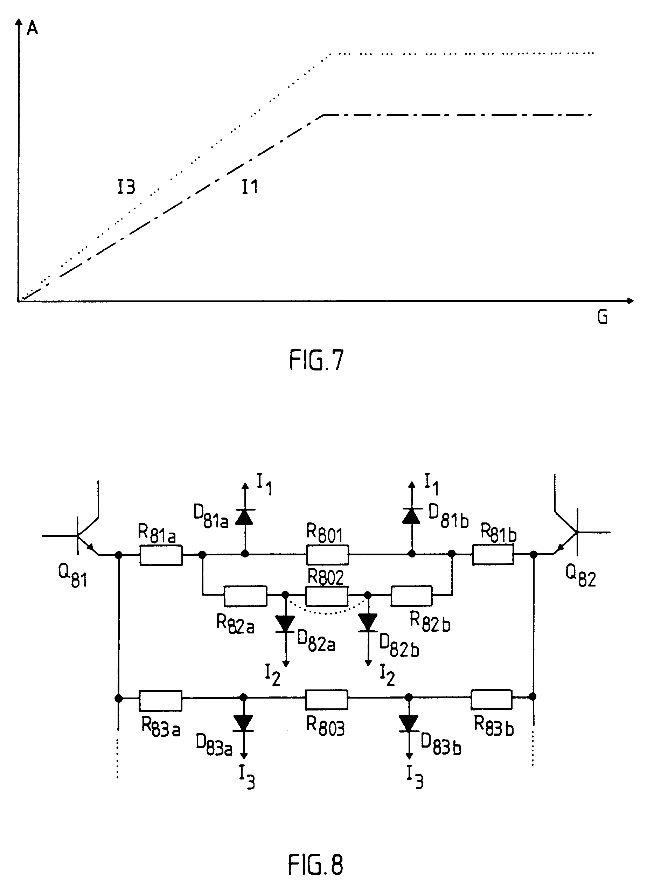

Bei einer Ansteuerung mit nur zwei Steuerströmen entsprechend Fig. 7 kann man eine lineare Regelcharakteristik erhalten. Dazu kann in Fig. 2 beispielsweise folgende Dimensionierung vorgenommen werden:
$R_{21}$ = $R_{22}$ = 3.0 kΩ
R1a = R1b = 100 Ω
R3a = R3b = 2.486kΩ
R4a = R4b = 158 Ω
R2a, R2b und I2 entfallen.

Anstelle des Netzwerks aus den acht in Reihe geschalteten Widerständen R1a-R4a und R1b-R4b, aus sechs jeweils zwischen diesen Widerständen abgehenden Bauelementen D1a-D3a und D1b-D3b und aus drei einseitig an Masse liegenden und an diese Bauelemente angeschlossenen Stromquellen I1-I3 in Fig. 2 kann auch das in Fig. 8 dargestellte Netzwerk verwendet werden.

Es sind jeweils in Serie zwischen den Emittern der den Transistoren $Q_{21}$ und $Q_{22}$ entsprechenden Transistoren $Q_{81}$ und $Q_{82}$ angeordnet:

- die Widerstände $R_{81a}$, $R_{801}$, $R_{81b}$ mit den zwischen ihnen abzweigenden Dioden $D_{81a}$ und $D_{81b}$, die an Stromquellen I1 angeschlossen sind;

- die Widerstände $R_{83a}$, $R_{803}$, $R_{83b}$ mit den zwischen ihnen abzweigenden Dioden $D_{83a}$ und $D_{83b}$, die an Stromquellen I3 angeschlossen sind;

- die Widerstände $R_{82a}$, $R_{802}$, $R_{82b}$ mit den zwischen ihnen abzweigenden Dioden $D_{82a}$ und $D_{82b}$, die an Stromquellen I2 angeschlossen sind, wobei die Widerstände $R_{82a}$ und $R_{82b}$ statt an die Emitter der beiden Transistoren an die Widerstände $R_{81a}$-$R_{801}$ bzw. $R_{81b}$-$R_{801}$ angeschlossen sind.
Parallel zu $R_{802}$ können weitere entsprechende Bauelemente und Stromquellen angeschlossen sein.

## Patentansprüche

1. Schaltung für einen regelbaren Verstärker, versehen mit einem Differenzverstärker für eine Eingangsspannung ($V_{in}$), der einen ersten Transistor ($Q_{21}$) und einen zweiten Transistor ($Q_{21}$) enthält, deren Emitter durch eine Serienschaltung von mindestens drei Widerständen ($R1a$-$R4a$, $R1b$-$R4b$) verbunden sind, wobei zwischen diesen Widerständen jeweils ein in seinem Widerstand steuerbares Bauelement ($D1a$-$D3a$, $D1b$-$D3b$) abzweigt, welches jeweils mit einer Stromquelle ($I1$, $I2$, $I3$) verbunden ist und wobei der Strom dieser Stromquellen in Abhängigkeit von der Eingangsspannung ($V_{in}$) veränderbar ist.

2. Schaltung nach Anspruch 1, **dadurch gekennzeichnet**, daß der Strom der Stromquellen ($I1$, $I2$, $I3$) zusätzlich von einer Referenzspannung ($V_{ref}$) abhängig ist, wobei die jeweilige Referenzspannung für die in der Mitte der Serienschaltung liegenden Bauelemente ($D3a$, $D3b$) am niedrigsten und für die am nächsten zu den Enden der Serienschaltung liegenden Bauelemente ($D1a$, $D1b$) am höchsten ist.

3. Schaltung nach Anspruch 1 oder 2, **dadurch gekennzeichnet**, daß die Bauelemente ($D1a$-$D3a$, $D1b$-$D3b$) Dioden und/oder als stromsteuerbare Widerstände ausgebildete FET-Transistoren sind, wobei insbesondere N-MOS- und P-MOS-Transistoren kombiniert werden.

4. Schaltung nach einem oder mehreren der Ansprüche 1 bis 3, **dadurch gekennzeichnet**, daß die Kennlinien (Fig. 3) der Ströme der Stromquellen ($I1$, $I2$, $I3$) in der Form 'Stromamplitude in Abhängigkeit von Verstärkung des Regelverstärkers' jeweils aus einem ansteigenden und aus einem flachen Anteil bestehen, wobei jeweils spätestens am Ende des ansteigenden Teils einer Kennline der ansteigende Teil der nächsten Kennlinie beginnt und wobei die jeweilige Referenzspannung ($V_{ref}$) Anfang und/oder Ende des ansteigenden Teils der Kennlinie festlegt.

5. Schaltung nach einem oder mehreren der Ansprüche 1 bis 4, **dadurch gekennzeichnet,** daß die Kennlinien (Fig. 4) der Ströme der Stromquellen ($I1$, $I2$, $I3$) im wesentlichen jeweils eine tangens-hyperbolicus-ähnliche Form haben.

6. Schaltung nach Anspruch 5, **dadurch gekennzeichnet**, daß die Regelcharakteristik für den regelbaren Verstärker im wesentlichen dB-linear oder linear ist.

7. Schaltung nach einem oder mehreren der Ansprüche 4 bis 6, **dadurch gekennzeichnet**, daß der flache Teil der Kennlinie für die in der Mitte der Serienschaltung liegenden Bauelemente ($D3a$, $D3b$) am niedrigsten ist und jeweils für die näher zu den Enden der Serienschaltung hin liegenden Bauelemente ($D1a$, $D1b$) höher liegt.

8. Schaltung nach einem oder mehreren der Ansprüche 4 bis 7, **dadurch gekennzeichnet,** daß mehrere erfindungsgemäße Regelverstärker hintereinandergeschaltet sind, wobei die Referenzspannungen ($V_{ref}$) für nachfolgende Regelverstärker jeweils höher sind als bei dem vorhergehenden.

9. Schaltung nach Anspruch 8, **dadurch gekennzeichnet**, daß jeweils ein entsprechendes Bauelement ($D1a$-$D3a$, $D1b$-$D3b$) aus mindestens zwei aufeinanderfolgenden Regelverstärkern an eine gemeinsame Stromquelle ($I1$, $I2$, $I3$) angeschlossen ist.

10. Schaltung nach Anspruch 8 oder 9, **dadurch gekennzeichnet**, daß die hintereinandergeschalteten Regelverstärker den wesentlichen Anteil eines integrierten ZF-Verstärker-Schaltkreises bilden.

11. Schaltung nach einem oder mehreren der Ansprüche 1 bis 10, **dadurch gekennzeichnet**, daß die Serienschaltung aus mindestens drei Widerständen aus mehrerern Serienschaltungen von Widerständen ($R_{81a}$, $R_{801}$, $R_{81b}$, $R_{82a}$, $R_{802}$, $R_{82b}$, $R_{83a}$, $R_{803}$, $R_{83b}$) besteht, wobei zwischen diesen Widerständen jeweils ein in seinem Widerstand steuerbares Bauelement ($D81a$-$D83a$, $D81b$-$D83b$) abzweigt, welches jeweils mit einer Stromquelle ($I1$, $I2$, $I3$) verbunden ist und wobei der Strom dieser Stromquellen in Abhängigkeit von der Eingangsspannung ($V_{in}$) veränderbar ist, wobei mindestens eine dieser Serienschaltungen aus mindestens drei Widerständen ($R_{82a}$, $R_{802}$, $R_{82b}$) statt an den ersten und zweiten Transistor an Widerstände ($R_{81a}$ bzw. $R_{81b}$) einer der anderen Serienschaltungen angeschlossen ist.

FIG.1

FIG.2

FIG.3

FIG.4

FIG.5

FIG.7

FIG.8

11

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 522 416 (STANDARD ELEKTRIK LORENZ AG)<br>* das ganze Dokument *<br>--- | 1 | H03G1/00<br>H03G7/06 |
| A | US-A-4 429 416 (R.W. PAGE)<br>* die Figur und die Zusammenfassung *<br><br>----- | 1,4-6 | |
| | | | **RECHERCHIERTE SACHGEBIETE (Int. Cl.5)**<br><br>H03G |

Der vorliegende Recherchenbericht wurde für alle Patentansprüche erstellt

| Recherchenort | Abschlußdatum der Recherche | Prüfer |
|---|---|---|
| DEN HAAG | 28 JULI 1992 | DECONINCK E. |

EPO FORM 1503 03.82 (P0403)